# EUROPÄISCHE PATENTANMELDUNG

(11) **EP 2 472 574 A2**
(43) Veröffentlichungstag der Anmeldung: **04.07.2012**
(21) Anmeldenummer: 11192975.8
(22) Anmeldetag: 12.12.2011
(51) Int. Cl.: H01L 21/60, H01L 23/482

(54) **Verfahren zur Herstellung einer Einpressdiode und Einpressdiode**

(30) Priorität: 28.12.2010 DE 102010064247
(71) Anmelder: Robert Bosch GmbH, 70442 Stuttgart (DE)
(72) Erfinder: Wolde-Giorgis, Daniel, 70771 Leinfelden-Echterdingen (DE); Sentuerk, Tuncay, 72762 Reutlingen (DE); Sueske, Erik, 72764 Reutlingen (DE); Hohenberger, Bernd, 73240 Wendlingen (DE); Klingler, Markus, 72555 Metzingen (DE); Kalich, Thomas, 72805 Lichtenstein (DE)

(57) **Zusammenfassung**

Die Erfindung betrifft ein Verfahren zur Herstellung einer Einpressdiode, die einen Sockel, einen Kopfdraht und einen zwischen den Sockel und den Kopfdraht gelöteten Halbleiterchip aufweist. Zunächst wird ein Halbleiterchip bereitgestellt, auf dessen Ober- und Unterseite jeweils eine bleifreie Legierung mit niedrigem Schmelzpunkt abgeschieden ist. Anschließend erfolgt ein Verbinden des Halbleiterchips mit dem Sockel und dem Kopfdraht mittels Diffusionslöten. Des Weiteren weist die Einpressdiode vorzugsweise elastisch und/oder plastisch verformbare Funktionsschichten auf, die im Betrieb durch Temperaturdifferenzen bedingte Beschädigungen des Halbleiterchips und des Lotes verhindern.

## Beschreibung

Die Erfindung betrifft ein Verfahren zur Herstellung einer Einpressdiode sowie eine Einpressdiode.

### Stand der Technik

Einpressdioden werden beispielsweise in Fahrzeugen bei der Gleichrichtung des Generatorstromes verwendet. Derartige Einpressdioden weisen einen Halbleiterchip auf, der zwischen einem Sockel und einem Kopfdraht der Einpressdiode eingelötet ist. Dieses Löten erfolgt unter Verwendung von hoch bleihaltigem Lot, beispielsweise Pb₉₆Sn₄. Hintergrund für die Verwendung dieses hoch bleihaltigen Lotes sind technische Anforderungen bezüglich der Temperatur im Betrieb sowie bezüglich der Temperaturwechselbelastungsfähigkeit der Einpressdiode.

Im Rahmen einer Initiative der EU, deren Ziel eine Reduzierung von Blei in der Fahrzeugelektronik ist, wird derzeit nach Alternativen für das genannte Löten mit hoch bleihaltigen Loten geforscht.

### Offenbarung der Erfindung

Ein Verfahren mit den im Anspruch 1 angegebenen Schritten erlaubt eine Bereitstellung von Einpressdioden, die die Vorteile einer bleihaltigen Einpressdiode mit den Vorteilen der des Weiteren eingesetzten bleifreien Verbindungen in sich vereinen. Derartige Einpressdioden entsprechen einer Weiterentwicklung der heute in Millionenstückzahl auf den Markt eingesetzten bleihaltigen Einpressdioden zur Bereitstellung von bleifreien Einpressdioden. Die durch den Diffusionsprozess gebildete Verbindungsschicht zeichnet sich durch eine sehr geringe Dicke aus, die kleiner ist als 15 µm, und gewährleistet eine hohe elektrische und thermische Leitfähigkeit. Durch diesen Aufbau einer Einpressdiode kann die Temperaturbelastung des Halbleiterbauteils signifikant gesenkt werden. Durch die Ausbildung der Verbindungsschicht als intermetallische Verbindungsschicht mit hohem Schmelzpunkt können im Betrieb Temperaturen akzeptiert werden, die oberhalb der Prozesstemperatur des Lötvorganges liegen. Folglich ist der Temperatur-Arbeitsbereich der Einpressdiode im Vergleich zu bekannten Einpressdioden, welche herkömmliche bleihaltige Lotverbindungen aufweisen, deutlich vergrößert.

Sind zwischen dem Chipkörper des Halbleiterchips und dem Sockel und zwischen dem Chipkörper des Halbleiterchips und der Verbindungsschicht elastisch oder plastisch verformbare Funktionsschichten vorgesehen, dann werden im Betrieb der Einpressdiode durch Temperaturdifferenzen entstehende mechanische Spannungen durch elastische oder plastische Verformung abgebaut, so dass eine Beschädigung des Halbleiterbauteils und des Lotes über die Lebensdauer der Einpressdiode ausgeschlossen werden kann.

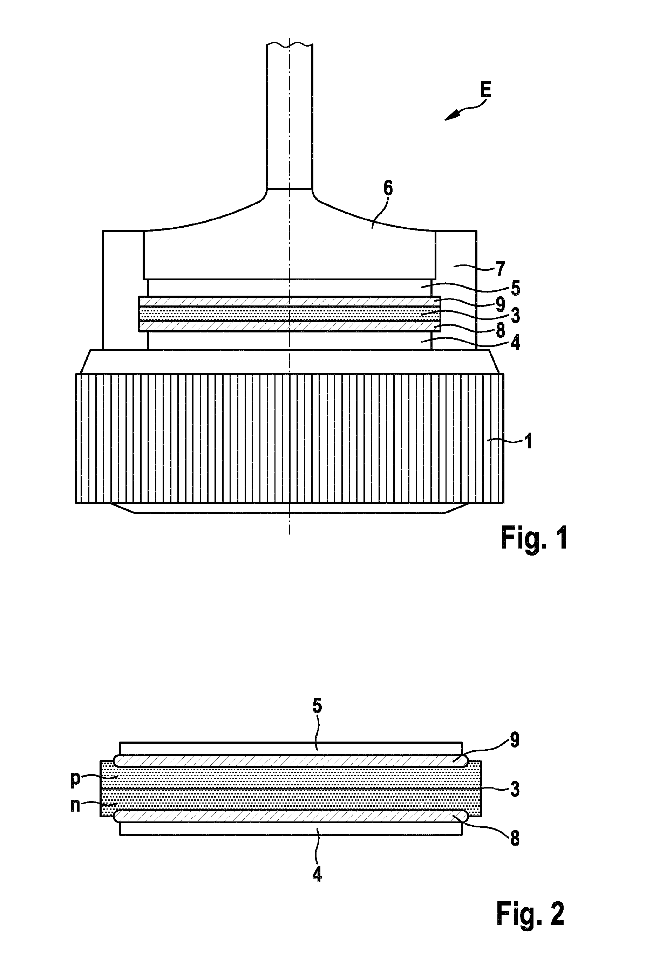

Nachfolgend wird die Erfindung anhand der Figuren 1 und 2 näher erläutert. Es zeigt
- Figur 1: eine Skizze eines Ausführungsbeispiels für eine Einspressdiode gemäß der Erfindung und
- Figur 2: eine Skizze zur Erläuterung des Aufbaus eines Halbleiterchips vor dem Montageprozess.

Die Erfindung betrifft ein Verfahren zur Herstellung einer Einpressdiode, die einen Sockel, einen Kopfdraht und einen zwischen dem Sockel und dem Kopfdraht gelöteten Halbleiterchip aufweist. Gemäß diesem Verfahren erfolgt zunächst eine Bereitstellung des Halbleiterchips, auf dessen Ober- und Unterseite jeweils eine bleifreie Legierung mit niedrigem Schmelzpunkt abgeschieden ist. Danach erfolgt ein Verbinden des Halbleiterchips mit dem Sockel und dem Kopfdraht mittels Diffusionslöten, wobei die genannte Legierung des Halbleiterchips ebenso wie die jeweilige Kontaktfläche des Sockels und des Kupferdrahtes aufgeschmolzen und miteinander verbunden werden.

Eine Skizze eines Ausführungsbeispiels für eine Einpressdiode, wie sie durch ein Verfahren gemäß der Erfindung hergestellt werden kann, ist in der Figur 1 gezeigt. Diese Einpressdiode E weist einen mit einer Rändelung versehenen Sockel 1 auf, der beispielsweise in einem Kraftfahrzeug-Generator-System in eine entsprechende Aussparung einer Gleichrichteranordnung eingepresst werden kann. Der Sockel 1 übernimmt dabei gleichzeitig eine dauerhafte thermische und elektrische Verbindung der Gleichrichterdiode mit der Gleichrichteranordnung. Der Sockel 1 weist einen Befestigungsbereich auf, an welchem ein Halbleiterchip 3, bei welchem es sich beim gezeigten Ausführungsbeispiel um eine Diode handelt, durch ein Lot 4, 5 befestigt ist.

Zwischen dem Lot 4 und dem Halbleiterchip 3 ist eine Funktionsschicht 8 vorgesehen. Zwischen dem Lot 5 und dem Halbleiterchip 3 ist eine Funktionsschicht 9 vorgesehen.

Die Figur 2 zeigt eine Skizze zur Erläuterung des Aufbaus des Halbleiterchips, wie er für den Montageprozess zur Verfügung gestellt wird. Bei diesem Halbleiterchip 3 handelt es sich beim gezeigten Ausführungsbeispiel um eine Diode, die einen p-datierten Bereich und einen n-dotierten Bereich aufweist, zwischen welchen sich ein pn-Übergang befindet.

Auf der Unterseite des Halbleiterchips 3 ist eine bleifreie Legierung 4 abgeschieden, auf der Oberseite des Halbleiterchips 3 eine bleifreie Legierung 5. Der Schmelzpunkt dieser Legierung ist niedrig. Er liegt vorzugsweise in einem Bereich von < 300 °C. Die genannte Legierung wird mittels eines Halbleiterprozesses, vorzugsweise durch Sputtern, aufgebracht. Bei den genannten Legierungen 4 und 5, die bleifrei sind, handelt es sich jeweils um eine dünne Schicht mit einer Schichtdicke, die kleiner ist als 15 µm. Die genannten Legierungen sind beispielsweise SnCu-Legierungen; SnAg-Legierungen oder SnAu-Legierungen.

Zwischen der Unterseite des Halbleiterchips 3 und der Legierung 4 ist eine Funktionsschicht 8 vorgesehen. Zwischen der Oberseite des Halbleiterchips 3 und der Legierung 5 ist eine Funktionsschicht 9 vorgesehen. Diese Funktionsschichten sind elastisch und plastisch verformbar und haben die Aufgabe, im Betrieb der fertig gestellten Einpressdiode auf Grund von Temperaturdifferenzen entstehende mechanische Spannungen abzubauen, so dass eine Beschädigung des Halbleiterbauelementes und auch des Lotes über die Lebensdauer der Einpressdiode ausgeschlossen werden kann.

Zur Herstellung einer Einpressdiode wird der Halbleiterchip 3, der mit den beiden Funktionsschichten 8 und 9 und den darauf abgeschiedenen bleifreien Legierungen 4 und 5 versehen ist, mittels eines Diffusionslötens zwischen dem Sockel 1 und dem Kopfdraht 6 montiert. Bei diesem Diffusionslötprozess wird die Legierung 4, 5, die einen vergleichsweise niedrigen Schmelzpunkt hat, umgeschmolzen, wobei gleichzeitig durch die Diffusion an der Kontaktfläche zum Sockel 1 einerseits und zum Kopfdraht 6 andererseits eine intermetallische Phase entsteht. Diese zeichnet sich dadurch aus, dass sie einen Schmelzpunkt aufweist, der größer ist als die Prozesstemperatur des Lötprozesses. Während des Lötprozesses erstarrt die Lotschicht durch die genannte intermetallische Reaktion.

Die resultierende Verbindungsschicht (siehe Lot 4, 5 in Figur 1) zeichnet sich durch eine sehr geringe Dicke aus, die kleiner ist als 15 µm. Auf Grund dieser Verbindungsschicht kann eine hohe elektrische und thermische Leitfähigkeit gewährleistet werden. Im Betrieb der Einpressdiode ist auf Grund des beschriebenen Aufbaus die Temperaturbelastung des Halbleiters, im vorliegenden Fall der Diode, signifikant gesenkt. Durch die Ausbildung der Verbindungsschicht als intermetallische Verbindungsschicht mit hohem Schmelzpunkt können im Betrieb der Einpressdiode Temperaturen zugelassen werden, die höher sind als die Prozesstemperatur des Lötprozesses. Dadurch ist der Temperatur-Arbeitsbereich der Einpressdiode im Vergleich zu bekannten Einpressdioden deutlich erhöht.

Montagebedingte oder betriebsbedingte mechanische Spannungen, die auf Temperaturdifferenzen zurückzuführen sind, werden in den Funktionsschichten 8 und 9 durch eine plastische und/oder elastische Verformung abgebaut. Dadurch ist sichergestellt, dass über die Lebensdauer der Einpressdiode keine Beschädigungen des Halbleiterbauelements selbst und auch keine Beschädigung des Lotes 4, 5 auftreten können, die auf Temperaturdifferenzen zurückzuführen sind.

## Patentansprüche

1. Verfahren zur Herstellung einer Einpressdiode (E), die einen Sockel (1), einen Kopfdraht (6) und einen zwischen den Sockel und den Kopfdraht gelöteten Halbleiterchip (3) aufweist, mit folgenden Schritten:
- Bereitstellung eines Halbleiterchips (3), auf dessen Ober- und Unterseite jeweils eine bleifreie Legierung (4, 5) mit niedrigem Schmelzpunkt abgeschieden ist und
- Verbinden des Halbleiterchips (3) mit dem Sockel (1) und dem Kopfdraht (6) mittels Diffusionslöten.

2. Verfahren nach Anspruch 1, **dadurch gekennzeichnet, dass** der Schmelzpunkt der Legierung im Bereich von < 300 °C liegt.

3. Verfahren nach Anspruch 1 oder 2, **dadurch gekennzeichnet, dass** die Legierung (4, 5) durch Sputtem aufgebracht ist.

4. Verfahren nach einem der vorhergehenden Ansprüche, **dadurch gekennzeichnet, dass** die Dicke der Legierung auf der Ober- und Unterseite des Halbleiterchips jeweils kleiner als 15 µm ist.

5. Verfahren nach einem der vorhergehenden Ansprüche, **dadurch gekennzeichnet, dass** während des Diffusionslötens eine intermetallische Phase entsteht, die einen Schmelzpunkt aufweist, der höher ist als die Prozesstemperatur des Lötprozesses.

6. Verfahren nach einem der vorhergehenden Ansprüche, **dadurch gekennzeichnet, dass** als Legierung (4, 5) eine SnCu-Legierung, eine SnAg-Legierung oder eine SnAu-Legierung verwendet wird.

7. Verfahren nach einem der vorhergehenden Ansprüche, **dadurch gekennzeichnet, dass** ein Halbleiterchip (3) bereitgestellt wird, der auf seiner Ober-
und Unterseite zwischen dem Chipkörper und der Legierung (4, 5) jeweils eine verformbare Funktionsschicht (8, 9) aufweist.

8. Verfahren nach Anspruch 7, **dadurch gekennzeichnet, dass** die Funktionsschicht elastisch und/oder plastisch verformbar ist.

9. Einpressdiode (E), die einen zwischen einem Sockel (1) und einem Kopfdraht (6) gelöteten Halbleiterchip (3) aufweist, wobei der Halbleiterchip mit dem Sockel und dem Kopfdraht mittels Diffusionslöten verbunden ist.

10. Einpressdiode nach Anspruch 9, **dadurch gekennzeichnet, dass** die Verbindungsschicht (4, 5) zwischen dem Halbleiterchip und dem Sockel und zwischen dem Halbleiterchip und dem Kopfdraht jeweils einen Schmelzpunkt aufweist, der höher ist als die Prozesstemperatur des Lötprozesses.

11. Einpressdiode nach Anspruch 9 oder 10, **dadurch gekennzeichnet, dass** die Verbindungsschicht (4, 5) eine SnCu-Verbindungsschicht, eine SnAg-Verbindungsschicht oder eine SnAu-Verbindungsschicht ist.

12. Einpressdiode nach einem der Ansprüche 9 bis 11, **dadurch gekennzeichnet, dass** sie zwischen dem Chipkörper und der Verbindungsschicht eine verformbare Funktionsschicht (8, 9) aufweist.

13. Einpressdiode nach Anspruch 12, **dadurch gekennzeichnet, dass** die Funktionsschicht elastisch und/oder plastisch verformbar ist.
